# EUROPEAN PATENT APPLICATION

(11) **EP 3 301 682 A1**
(43) Date of publication of application: **04.04.2018**
(21) Application number: 16464009.6
(22) Date of filing: 14.10.2016
(51) Int. Cl.: G21B 1/13

(54) **HIGH POWER TW/PW LASER IRRADIATION**

(30) Priority: 03.10.2016 RO 698
(71) Applicant: National Institute for Laser, Plasma and Radiation Physics, Ilfov (RO)
(72) Inventor: National Institute for Laser, Plasma and Radiation Physics, Ilfov (RO); Lungu, Petrica Cristian, Bucuresti (RO); Porosnicu, Corneliu-Constantin, Ilfov (RO); Jepu, Ionut, Ilfov (RO); Lungu, Mihail, Bucuresti (RO); Banici, Romeo, Buzau (RO); Marcu, Aurelian, Bucuresti (RO); Luculescu,, Bucuresti (RO); Ursescu, Daniel, Bucuresti (RO)

(57) **Abstract**

The present invention refers to the method used to form diamond nano-sized structures on certain substrates made from interest materials for nuclear fusion using lasers in impulses. The present invention uses short laser beams (fs, ps) produced with a repetition rate of 1- 10 Hz, and wavelength from around 750 nm until around 850 nm, the most frequent at a frequency of 800 nm in vacuum or gaseous atmosphere (air or deuterium).

The mixed films containing Be, C, W were obtained using the thermionic vacuum arc method (TVA). These films have thicknesses of 0.1 - 10 µm and interact directly with single or multiple laser beams as well as with the plasma produced by indirect laser beam irradiation in ambient gases as air or deuterium. The laser pulses produce diamond or fullerene nanostructures on the irradiated mixed materials surface.

By this method, the irradiated material is processed in a non-thermal mechanism. Multiphotonic interactions and collision ionizations combination creates plasmas in the impact areas of shorter term than the kinetic electron energy that can be transferred in the material. The produced plasma is not in thermal equilibrium, the irradiated material being changed from initial solid state in totally ionized plasma in such a short time that the thermal equilibrium can not be reached. As a result, a negligible thermal transfer to the layers outside the interaction area occurs. The transition of this non-thermal regime to the thermal regime depends on the irradiated material and it is in the range 1 to 20 ps. Due to the fact that the unexposed area heating is negligible, the adjacent material composition is substantially unaffected by the irradiation process proposed in the present invention.

## Description

### 1. Field of invention

The invention refers to a method to obtain nano-size layers with diamond or fullerene content by ultra short laser pulses (picoseconds -ps, femptoseconds-fs) produced by high power lasers (terawatt-TW/ petawatt-PW) and refers specially to a process regarding the formation of diamond/ fullerene structures on interest layers for nuclear fusion, carbon, beryllium and tungsten respectively.

### 2. Current stage of the field

Energy production using fusion plasma is a desired goal and an extremely well explored research field in the world. Currently, the most advanced method to produce nuclear fusion reactions is that of hot plasma, magnetically confined in a tokamak-like reactor.

The fusion facility ITER (International Thermonuclear Experimental Reactor) that will be operated at Cadarache, France, it is probably the biggest scientific project ever developed. An important issue still unsolved is the composition of main chamber wall, materials that must resist at energy fluxes of 10-100 MW/m². These energy fluxes occur during plasma instability, when the magnetic field lines lose their stable configuration and the ionized plasma particles with energies over 10 eV are directed towards the first wall. As instabilities examples can be mentioned the localized modes at the edges (ELMs), breakdowns, etc. For this, as wall protection it was proposed the use of W tiles in the divertor area, knowing the desired properties: reduced sputtering rate and high melting point. The other materials are (as composite carbon fiber - CFC) and beryllium (a light element with relatively high melting point - 1551.15 K). Although, W, C and Be behavior at high energy fluxes is not entirely known and it is well studied nowadays.

In the present are known methods for testing and changing the interest materials for fusion as the irradiation system JUDITH with electron beam at the Research Center Julich, Germany(Th. Loewenhoff, J. Linke, G. Pintsuk, C. Thomser, Tungsten and CFC degradation under combined high cycle transient and steady state heat loads, Fusion Engineering and Design, Volume 87, Issues 7-8, August 2012, Pages 1201-1205*;* C. Thomser, A. Schmidt, B. Bellin, A. Buerger, J. Linke, M. Roedig, F. Zacchia, High heat flux testing of beryllium components with improved diagnostics, Fusion Engineering and Design, Volume 86, Issues 9-11, October 2011, Pages 2409-2412*).*

The acceleration voltage in this system is high (120 kV) and it produces a relatively high penetration in the exposed targets. In light materials, the beam rather produces loads with volumetric power more than surface loads.

The technical issue that the invention solves consists in using for interaction pure or mixed materials with laser shots of ultra short length produced with high power laser in the terawatt range. This is a laser that can produce a density of power until 10¹⁴ W/cm² by focusing the laser beam on a spot with the diameter of tens of microns. The study concerning the behavior of layers deposited with thickness between 0.1 and 10 microns in single pulse regime or multi-pulses can be rapidly achieved using the TEWALAS laser. The pulses can be programmed to have short duration of nanoseconds or picoseconds at frequencies of several Hz or kHz thus cumulated to be obtained duration and densities of powers comparable to the instabilities in fusion plasmas.

The present invention refers to the formation method of nanometric diamond structures on certain substrates made from interest materials for nuclear fusion using lasers in impulses. The present invention uses laser pulses of very short duration (fs, ps) produced with a repetition rate of 1-10Hz and a wavelength from around 750 nm until 850 nm, the most frequent at frequency of 800 nm in vacuum or gas atmosphere (air or deuterium). A very small part of material, less than 10 nm, can be removed for a laser pulse with a very small energy transfer by shocks or thermal conduction out the interest volume. The area adjacent to the irradiated area is not affected by laser pulse that induces the desired changes only in the interest area.

The mixed films containing Be, C and W were obtained using the thermionic vacuum arc (TVA) method presented in detail in the patent no. RO 128030 B1. These films have thicknesses between 0.1 - 10 µm and interact directly with single or multi laser shots, as well as with the plasma produced with laser beam in ambient gases as air or deuterium. The laser shots produce diamond or fullerene nanostructures at the surface of the irradiated mixed materials. The structures formed in the treated substrates (diamond nanometric crystals) constitute useful elements in improving material characteristics as mechanical properties (diminish the friction coefficients in dry regime, hardness increase) to diminish the retention of nuclear fuel for the materials used for the first wall of tokamak like fusion facilities.
By this method, the irradiated material is processed by a non-thermal mechanism. A combination between multi-photonic interactions and collision ionizations create plasmas in the impact areas in a shorter period of time than the time needed for the transfer of the kinetic energy of the electrons affected to the adjacent areas. The produced plasma is not in thermal equilibrium, the irradiated material being transformed from initial solid state in complete ionized plasma in such a short time that the thermal equilibrium can not be reached. As a result, is produced a negligible heat transfer to the layers out of the interaction area. The transition of this non-thermal regime to the thermal transfer regime depends on the irradiated material and it is in the range 1 to 20 ps. Because the heat of the unexposed area is negligible, the composition of the adjacent material is substantially unaffected by the irradiation process proposed in the present invention.

### Example 1.

It is presented the formation of nanodiamond structures in a bi-layer of carbon and tungsten deposited on graphite substrate.

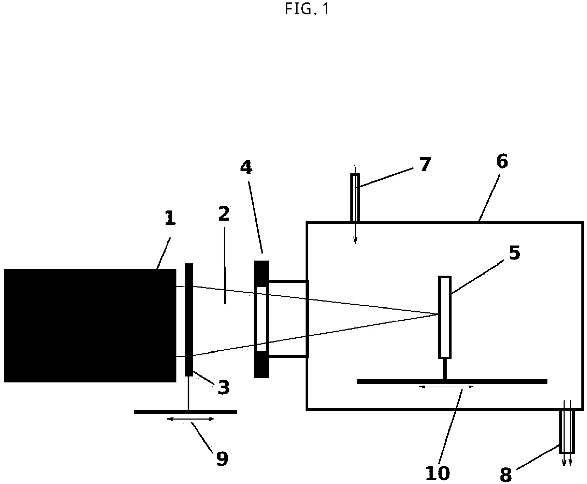

In connection with figure 1, a system, according to the invention consists in a power laser (1), which is an amplification laser system of more than a terawatt with pulse duration of 25 fs until 360 ps, with pulse energy until 400 mJ and 10 Hz maximum repetition rate. The laser delivers laser beams with wavelength in the range 750 -850 nm, 800 nm especially. A power density of 10¹² - 10¹⁴ W/cm² per pulse can be achieved, power density similar to that in fusion facilities.

The laser system irradiates the substrate perpendicularly as it is shown in Fig. 1. The beam (2) produced by the laser (1) is focused using a lens with focal distance of 60 cm(3) passing through the window (4) on the target (5). The target is supported by a mobile holder (10) which helps to establish the laser beam interaction area with the target. To adjust the laser spot, a mobile holder (9) of the focusing lens (3) is used. The target (5) is inside the chamber, vacuumed through the vacuum pump (8), until a limit vacuum of 10⁻⁷ mbar. The working chamber can be inserted with air at atmospheric pressure or deuterium at 170 mbar pressure using the valve (7).

The films formed by a bi-layer of W and C deposited on graphite substrate by thermionic vacuum arc method were irradiated with laser pulses of 100-150 mJ and duration of 360-ps and 100-fs under high vacuum conditions (pressure < 10⁻⁵ mbar). Combined irradiations of long-term pulses followed by short-term pulses were also used.

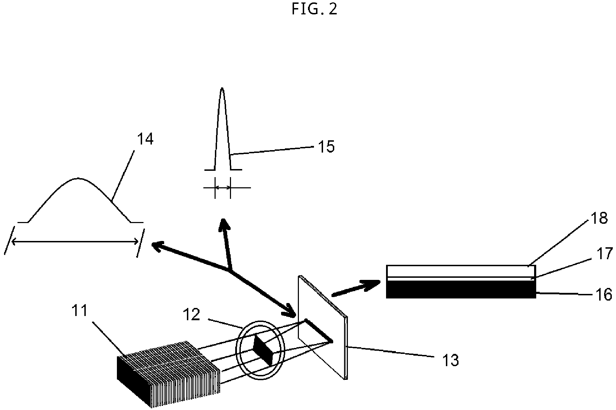

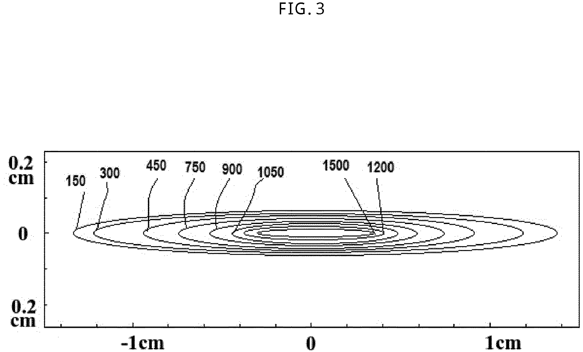

A detailed scheme of C/W/graphite irradiated layers is presented in Fig. 2, thus the laser (11) is focused through the lens (12) towards the target (13). The laser beam shape in the impact area is of maximum 2 mm horizontally (14) and 0.5 mm vertically (15). The target consists in a substrate of 1 mm x 12 mm x 15 mm from graphite (16) on which a 200 nm tungsten layer is deposited (17) followed by a 2000-2500 nm carbon layer (18). The power density distribution of the laser beam is presented in Fig. 3.

Carbon film deposition (around 200 nm) and tungsten (around 2000 nm) was performed using thermionic vacuum arc method, presented in the article C. P. Lungu, I. Mustata, V. Zaroschi, A. M. Lungu, A. Anghel, P. Chiru, M. Rubel, P. Coad G. F. Matthews and JET-EFDA contributors, Beryllium Coatings on Metals: Development of Process and Characterizations of Layers, Phys. Scr. T128 (March 2007) 157-161 and in the patent no. RO 128030 B1.

The parameters for W deposition are: U_{arc} =1.8 kV, I_{arc} = 1.8 A, P = 1.3 10⁻⁴ Pa, for 5 minutes, total thickness 200nm, while for C deposition the parameters are: : U_{arc} = 0.9 kV, I_{arc} = 2.5 A, P = 2*10⁻³ Pa, for 28 minutes, total thickness 2000 nm.

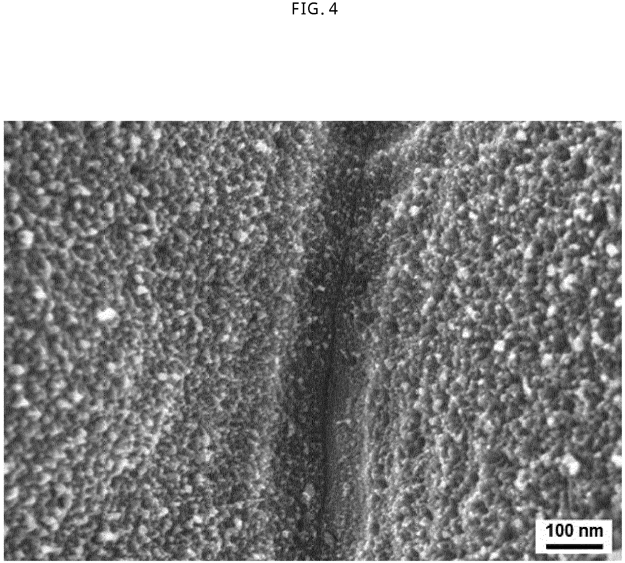

Due to the irradiation with laser pulses, the carbon layer is removed (laser ablation) in the central area of the irradiated area after the first few pulses; during the next pulses the W layer is removed and then the laser pulse interacts with the graphite substrate. Nevertheless, due to the Gaussian profile of laser beam energy it results weaker interactions in the lateral areas. Due to laser irradiation, uniform areas are formed as drops shaped, near the crater created in the central impact area of the laser beam (Fig. 4). The formed drops show the marks of a nucleation and re-crystallization due to the re-solidification process.

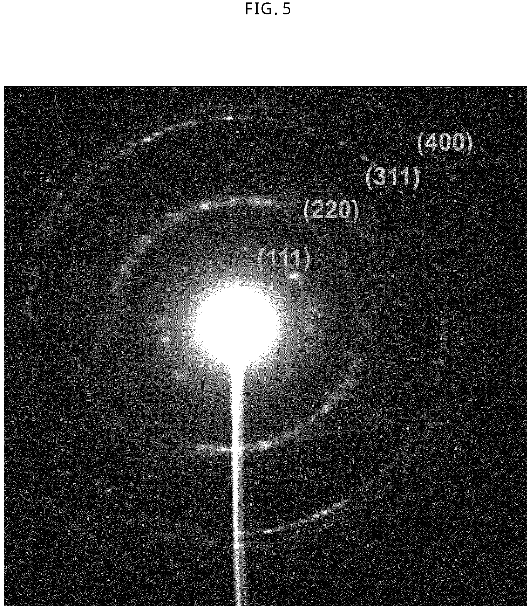

In the processed area, rhomboidal structures are identified, with lattice parameters a = 0.25221 nm, c = 4.3245nm (Fig. 5) corresponding to diamond. The interplanar distances were calculated using the mutual space identified by electron diffraction in selected area (SAED) obtained by electron transmission microscopy (TEM).

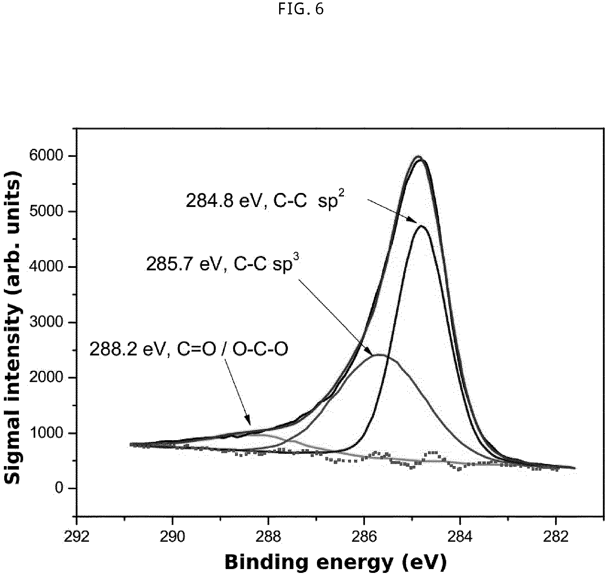

The fraction sp³ corresponding to diamond bonding was deduced by fitting the XPS spectra for C1s spectral lines of carbon (Fig. 6). Except the irradiation area the spectral lines corresponding to contamination with CO (290.4 eV, O=C-O and 288.2 eV, C=O/O-C-O) and graphite (284.8 eV, C-C sp²) have a greater contribution than those attributed to the lines corresponding to diamond bonding (285:7 eV, C-C sp³). The sp³ bonding content is estimated from the area corresponding to diamond and the sum of the overlapped lines of graphite and CO phases. An estimation of the sp³ bonding content inside the exposed surface was 39.4%, in comparison with 30.8% percentage in the non-irradiated area. Because XPS is a sensible method for surface analysis, it can be estimated the value of sp³ fraction if the thickness of the analyzed film is bigger than the average free path of the electrons. To confirm the content of diamond nanocrystals, Raman analysis technique it was used. In Fig, 7, the Raman spectra obtained using excitation wavelength laser radiation analysis of 633 nm are presented for the area inside the crater (a), near the crater (b) and are compared with Raman spectra of a diamond peak (c) and graphite substrate (d). Thus it is highlighted the presence of diamond nanocrystals in agreement with the results presented by Nüske et al [Nüske R., Jurgilaitis A., Enquist H., Harb M., Fang Y., Håkanson U., Larsson J., Transforming graphite to nanoscale diamonds by femtosecond laser pulse, Applied Physics Letters 100, 043102 (2012) Nüske R., Jurgilaitis A., Enquist H., Harb M., Fang Y., Håkanson U., Larsson J., Transforming graphite to nanoscale diamonds by femtosecond laser pulse, Applied Physics Letters 100, 043102 (2012)].

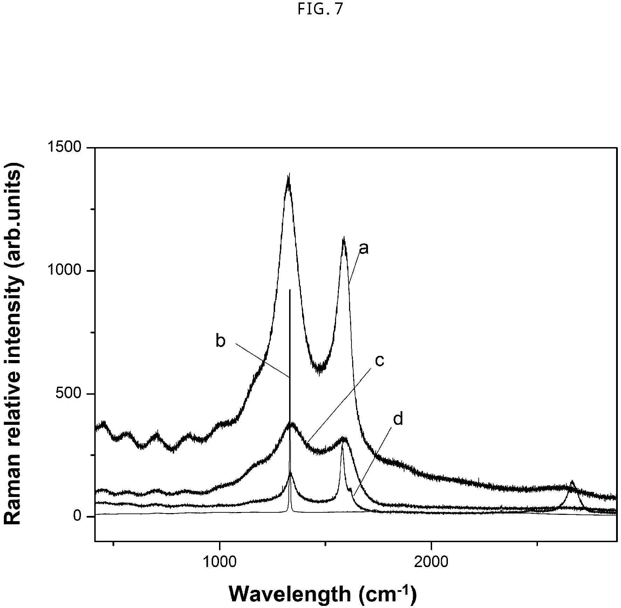

The spectra in Fig. 7 mainly show the spectral band D and G for carbon corresponding to sp² bonding. A wide band at around 1120 cm⁻¹ is also visible. We consider it to come from the nanometric diamond crystals contribution. This is confirmed by XPS and SAED measurements together with the interpretations from other papers as the discussed films obtained using TVA are hydrogen free. Raman spectra confirm the existence of a mixture of diamond and graphite nanocrystallites included in an amorphous carbon lattice. G band is an active Raman phonon of graphite crystal. As a result, it can not be dispersed in graphite while in the irregular carbon its dispersion is proportional with the irregularity degree from the configurations with different local energy levels and different phononics.

Raman spectra confirm the presence of a mixture of diamond-graphite nanocrystals included in an amorphous carbon lattice. From the arial D and G band ratios the diamond particle diameter is estimated between 1.5 and 2.3 nm. Micro-Raman measurements in the laser radiation processed area compared to diamond spectra peak show that Raman line from 1330 cm⁻¹ is highly enlarged thus to conclude that it is a discontinuous diamond structure. SEM images (Fig. 4) together with the energy dispersive spectrometry (EDS) analysis prove the existence of W particles in diamond-graphite structure in the irradiated area.

### Example 2

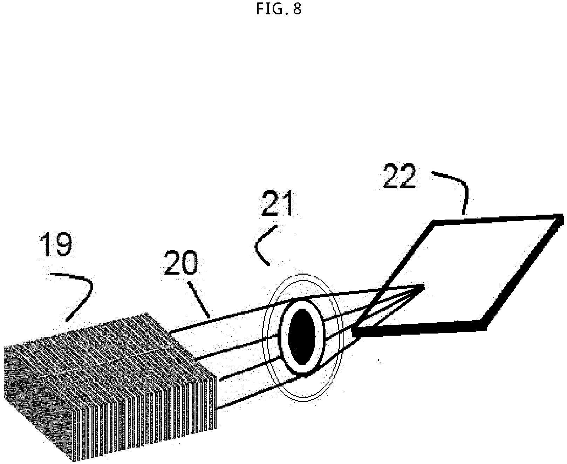

In the second example, the mixed coatings containing Be, C, W were exposed to a plasma formed in air (normal conditions) and deuterium (~ 20 mbar) by focusing high power laser pulses near the target surface using the TEWALAS laser, "Ti: Saphire laser system", ∼100 fs pulse duration on single or multi pulse at 800nm wavelength. The energy on pulse was around 4 mJ, while the number of pulses was between 1 and 1000 pulses at a repetition rate 10Hz. Due to the high intensity obtained in the focal point, it took place a breakdown of gas at a distance around 0.3 mm against the target generating air plasma and deuterium plasma respectively. The plasma produces in the focal spot around 0.3 mm against the sample surface shows similar characteristics to nuclear fusion plasma(energy fluxes 10-100 MW/m² and ionized particles with temperatures over 10eV). From the generic set-up in Fig. 8 it can be seen the laser (19) emits a beam (20) focused by the lens (21) and oriented to the target (22) that is at an angle around 5° against the incident laser beam direction.

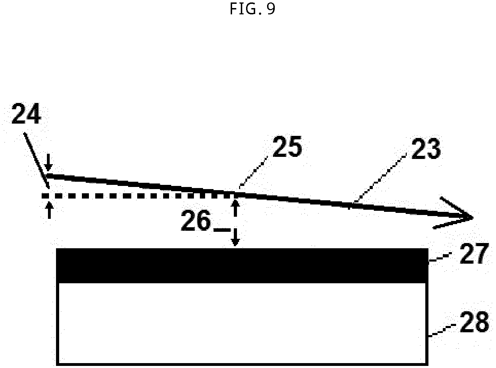

In detail, in Fig. 9 it is shown the laser beam (23) focused in the focal spot (25) over the target at around 0.3 mm (26) at an angle around 5° (24) against laser beam direction. In the figure are shown the irradiated mixed film (27) and the substrate (28). The focal spot diameter (25) where the ambient gas (air or deuterium) breakdown is performed (filamenting) is estimated around 0.2 mm.

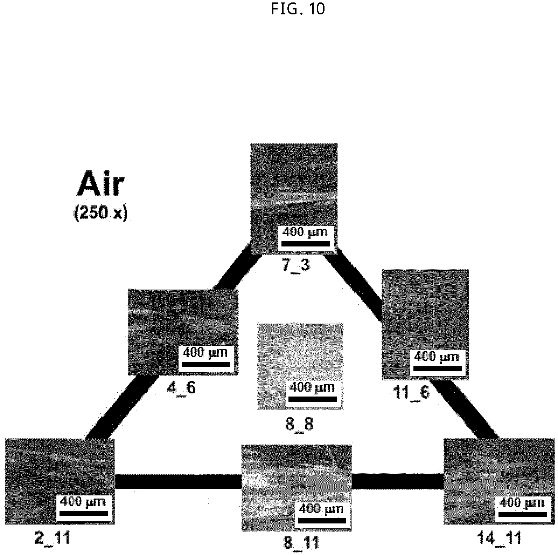

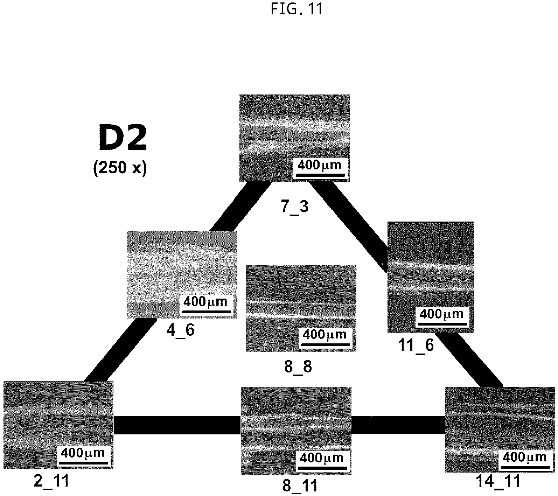

The mixed films containing Be, C, W were deposited by simultaneous evaporation from three evaporators used in the thermionic vacuum arc technology. The samples were placed on the deposition holder so that they obtain higher concentrations in the areas near the evaporators. Therefore, the samples numbered 2_11 had higher W concentrations, the samples numbered 14_11 had C higher concentrations, and the samples numbered 7_3 had Be higher concentrations. In fig. 10 and 11, it is shown the sample distribution on the deposition holder as well as the images of the affected areas by the interaction with the laser plasma, in ambient gas air and deuterium, respectively. The images were obtained with scanning electron microscope (SEM).

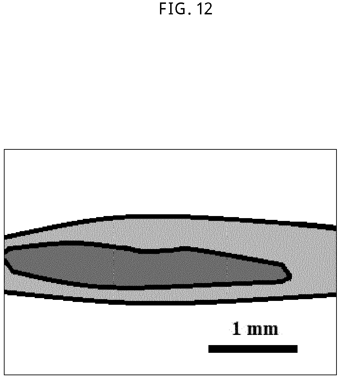

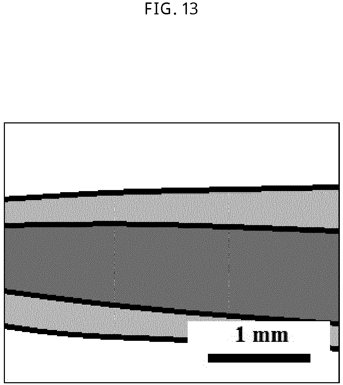

The plasma produced in the focal spot irradiated the Be/C/W mixed films and produced the change in morphology and structure of the irradiated areas. The composition and the ambient gas influenced the dimension of the irradiated areas. The ablation trace in the areas where W and C were in majority was wide, but also deuterium presence widened the ablated areas, the areas partially affected when the irradiation was performed in air respectively (Fig. 12) towards the broadening in the central area when the ambient gas was deuterium (Fig. 13).

In all the cases, the ablation process occurred in the center of the irradiated areas. Using EDS it was shown that in the irradiated areas, above the silicon substrate, the dominant element is W showing a preferential ablation of beryllium and carbon in those zones. Among an amplification of the proved ablation process by broadening the areas rich in W content, it can be shown a broadening of the areas rich in C content, suggesting that C is the element the most rapidly ablated under deuterium presence. It is noticed that in the air is less evident. Because the profile of laser beam is non-uniform and the energy tends to decrease at the periphery, it means that the ablation threshold (for a complete ablation) decreases in the presence of deuterium as ambient gas.

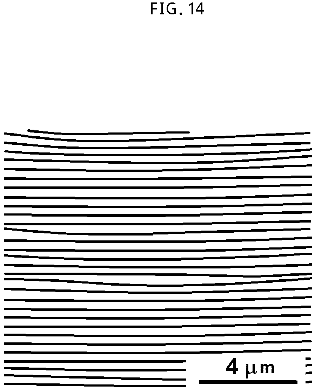

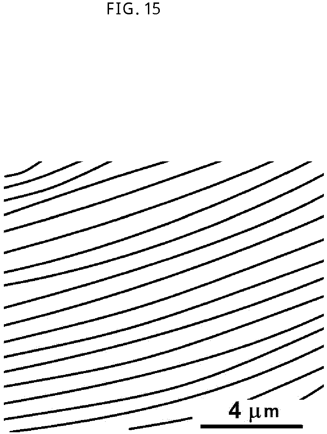

The nanostructures formed in the irradiated areas are ripples, whose period changes depending on the ambient gas, from around 250 nm distance from peak to peak, to around 500 nm peak to peak in deuterium presence. Fig. 14 shows ripples produced in the irradiated area in ambient air, and in air, and in Fig. 15, show ripples shape when the ambient gas was deuterium. The mechanism accepted for ripples formation is correlated to plasmon formation during laser-material interaction, mediated by electrons. The ambient gas composition plays a role in this process and the plasma formed by the laser affects the ablation threshold in the irradiated areas.

In the deuterium gas irradiated areas, roughness increase and drop formation are produced in the beryllium rich areas. This fact leads to beryllium melting and resolidification. These features are not observed in the C rich areas. The carbon is simple and rapidly removed in the presence of deuterium without the formation of drops on the irradiated surface.

XPS measurements quantified Be, C, W distribution in the samples prepared and showed the presence of oxygen in the r\beryllium rich areas, confirming beryllium oxidation and BeO formation in the structures formed in Be rich areas and also suggest a strict correlation between C percentage and C-C bonding concentration.

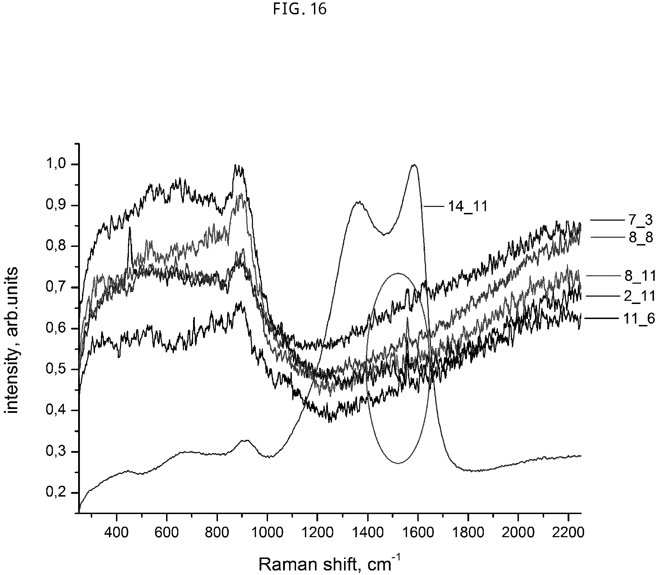

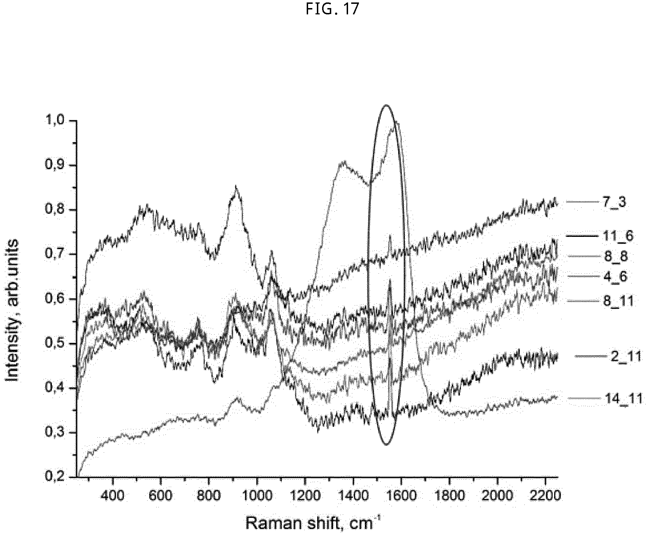

Raman investigations showed certain differences between the analyzed samples before and after deuterium exposure. Raman investigations on the unexposed samples were carried out and graphite band diagrams before and after deuterium exposure are presented in Fig. 16 and Fig. 17 respectively. It is highlighted a general tendency of graphite band from 1580 cm⁻¹ to increase after deuterium exposure. In the presence of deuterium and ionized deuterium particularly, G band is amplified showing the decrease of amorphous carbon.

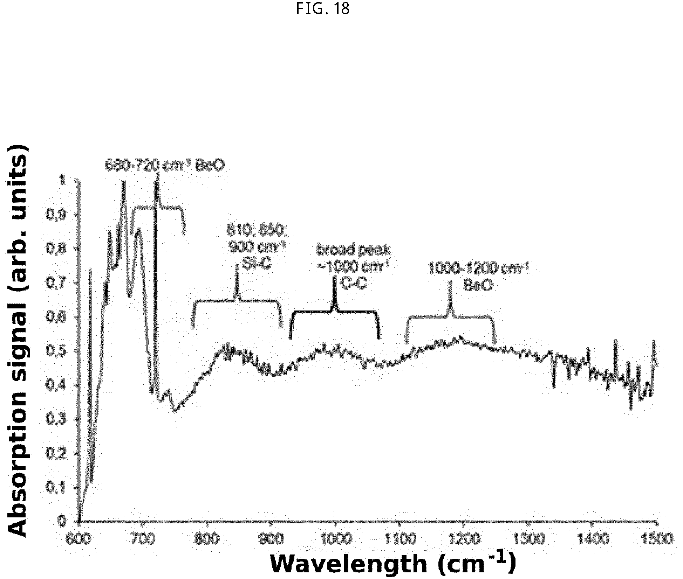

Furthermore, FTIR spectra were measured in the irradiated areas. A spectrum measured in the ablation area is shown in Fig. 18. FTIR spectra have several broaden spectral lines: an absorption band at 1100 cm⁻¹ that appears due to C-O-C vibrations. Because in the area 2800-2950cm⁻¹ were not observed C-H or C-D vibrations in the area 2100-2200 cm⁻¹ we conclude that the bands from 950-1050 cm⁻¹ correspond to aromatic circular bondings, confirming the presence of fullerene structures.

The bands from 860 cm⁻¹ show Si and W oxides presence.

Be micro-crystallites are highlighted by the presence of the band from 458 cm⁻¹.

In all the samples, the bands from 900-910 cm⁻¹ show the presence of W oxides.

The size of graphite/ fullerene grains was around 3 nm.

The presence of beryllium is proved by the band from 1460 cm⁻¹

The bands from 810, 850 and 900 cm⁻¹ show the presence of SiC and have the tendency to be present in all spectra. They suggest a reaction between the carbon layer and the substrate. The band in the range 1000-1200 cm⁻¹ and 680-720 cm⁻¹ confirm BeO presence in the ablation area.

### HIGH POWER TW/PW LASER IRRADIATION

### BRIEF DESCRIPTION OF THE FIGURES

Figure 1 represents a schematic view of direct irradiation process.
Figure 2 represents a detailed irradiation scheme of C/W layers deposited on graphite, including energy density profile in perpendicular plan on irradiation direction.
Figure 3 represents the energy distribution (mJ/Cm²) of the laser spot on the irradiated zone.
Figure 4 represents the image of the crater produced by laser beam obtained by scanning electron microscopy (SEM).
Figure 5 represents the image obtained by x-ray diffraction method on the selected areas (SAED) obtained by electron transmission microscopy (TEM).
Fig. 6 Cls XPS spectral line deconvolution corresponding to the zone outside the irradiation area.
Fig. 7 Raman spectra obtained using laser excitation wavelength of 633 nm: for the zone inside the crater (a), near the crater (b) and compared with Raman spectrum of a diamond-pin (c) and graphite substrate (d).
Fig. 8 Experimental set-up for indirect irradiation.
Fig.9 Detailed scheme for indirect irradiation.
Fig.10 Sample distribution above W, C, Be evaporators and SEM images of the interaction traces in air ambient gas.
Fig. 11 Sample distribution above W, C, Be evaporators and SEM images of interaction traces in deuterium ambient gas.
Fig 12. The shape of the interaction zone between the laser produced plasma and the sample in air ambient gas, in W rich area.
Fig 13. The shape of the interaction zone between the laser produced plasma and the sample in deuterium ambient gas.
Fig. 14 The shape of the ripples on the interaction zone between the laser produced plasma and the sample in air ambient gas.
Fig.15 The shape of the ripples on the interaction zone between the laser produced plasma and the sample in deuterium ambient gas
Fig. 16 Raman spectra for the samples in the unexposed areas.
Fig. 17 Raman spectra for the samples in the exposed areas at the laser produced plasma in deuterium ambient gas.
Fig. 18 FTIR spectrum measured in the ablation area.

## Claims

1. A method for changing a layer deposited on a graphite substrate and includes the following: (i) production by thermionic vacuum arc method of a bi-layer from carbon and tungsten with a thickness of 2000 -2500 nm W and 180-200 nm C on a graphite substrate with parallelepiped shape, (ii) directing certain laser beams on short duration (100 fs - 360 ps) in single pulses or multi-pulses of terawatt peak power (10¹² watt) until petawatt power (10¹⁵ watt), with pulse energies of micro-Joules, by a lens in a focal point of about 20 mm x 2 mm diameter to form by multi-photonic absorption diamond nano-crystals inserted in a amorphous carbon lattice.

2. The method, according to claim 1, where the laser beam is adjusted by a condensing lens mounted on a holder with two freedom degrees.

3. The method, according to claim 1, where the laser beam is focused in a predetermined point on sample surface by adjusting the sample position in a parallel plan to the beam but perpendicular on it with a holder with two freedom degrees.

4. The method, according to claim 1, where the bi-layer that forms the processed film contains carbon.

5. A method for changing a film deposited on a layer that contains: (i) production by thermionic vacuum arc of a mixed film that contains carbon, beryllium and tungsten deposited on silicon, (ii) directing certain laser beams on short term (100 fs - 360 ps) in single pulses, or multi-pulses of terawatt peak power (10¹² watt) until petawatt power (10¹⁵ watt), with pulse energies from micro-Joules to mili-Joule by a condensing lens in a focal point at 0.3 mm distance against film surface, (iii) formation in a plasma focal point in ambient environment air (normal pressure) or deuterium at 20 mbar pressure to produce structures with fullerene, beryllium oxide and/or tungsten oxide content.

6. The method, according to claim 5, where the laser beam is directed almost parallel to the sample surface, more precisely at 5 degrees angle.

7. The method, according to claim 5, where the produced plasma in the focal point at about 0.3 mm distance to sample surface shows similar characteristics with nuclear fusion plasma. (energy fluxes of 10-100 MW/m² and ionized particles with temperatures over 10 eV).

8. The method, according to claim 5 where the irradiated mixed film contains carbon.
